# EUROPEAN PATENT APPLICATION

(11) **EP 2 722 420 A2**
(43) Date of publication of application: **23.04.2014**
(21) Application number: 13189736.5
(22) Date of filing: 22.10.2013
(51) Int. Cl.: C30B 11/00, C30B 29/42

(54) **Equipment and method for producing a compound polycrystal, and method for growing a compound single crystal**

(30) Priority: 22.10.2012 JP 2012232916
(71) Applicant: HITACHI METALS, LTD., Minato-ku, Tokyo 105-8614 (JP)
(72) Inventor: Shibata, Masatomo, Tokyo, 105-8614 (JP); Inada, Tomoki, Tokyo, 105-8614 (JP)
(74) Representative: Betten & Resch

(57) **Abstract**

Method and equipment for producing a compound polycrystal and method for growing a compound single crystal. The method for producing the compound polycrystal that are synthesized from two or more source materials including a high vapor pressure source material having a vapor pressure higher than an atmospheric pressure at a synthesis reaction starting temperature includes accommodating a starting material including the source materials for the compound polycrystal in a reactor connected to outside through a pore, placing the reactor accommodating the starting material in a pressure vessel and enclosing the pressure vessel, substituting an atmosphere in the pressure vessel with an inert gas, and constantly pressurizing an inside of the pressure vessel with a pressure not lower than a highest vapor pressure of the source materials in the starting material by controlling a pressure of the inert gas while heating the reactor, to react the starting material, thereby synthesizing the compound polycrystal.

## Description

### BACKGROUND OF THE INVENTION

### 1. FIELD OF THE INVENTION

The invention relates to an equipment and a method for producing a compound polycrystal as well as a method for growing a compound single crystal.

### 2. DESCRIPTION OF THE RELATED ART

Conventionally, as a method for growing a single crystal, a method for providing a single crystal through a step of synthesizing a polycrystal as a raw material for the single crystal, and a step of growing the single crystal from a melt of polycrystal as the raw material for the single crystal has been known.

As one of methods for synthesizing a polycrystal as a raw material for a single crystal, a method for synthesizing a polycrystal in a crucible has been known, as disclosed by e.g. JP-A 2006-1771**,** H. Immenroth et.al., "Advanced arcenic purification and GaAs synthesis for improved reproducible growth of undoped semi-insulating GaAs", Journal of Crystal Growth 142 (1994) pp. 37-48**,** and M. Jurisch et.al., "LEC-and VGF-growth of SI GaAs single crystals --- recent developments and current issues", Journal of Crystal Growth 275 (2005) pp. 283-291**.** According to vertical boat method disclosed by JP-A 2006-1771 and the method for synthesizing a polycrystal disclosed by H. Immenroth et.al. and M. Jurisch et.al., the synthesizing, melting, and solidification of GaAs polycrystal as a raw material for a single crystal are carried out in the crucible. In the crucible, B₂O₃ is filled as a liquid encapsulating agent in addition to As and Ga as starting materials (source materials). B₂O₃ as the liquid encapsulating agent is used to prevent the sublimation and volatilization of As during the step of synthesizing GaAs polycrystal.

As another method for synthesizing a polycrystal as a raw material for a single crystal, a horizontal boat method for carrying out the synthesis in a boat placed in an ampoule has been known, as disclosed by JP-A 5-97594**,** JP-A 6-239699**,** and JP-A 11-268904**.** According to the horizontal boat method as disclosed by JP-A 5-97594**,** JP-A 6-239699**,** and JP-A 11-268904**,** solid starting materials placed in the boat, and other solid starting materials and other vapor (gas) starting materials are encapsulated in an ampoule to synthesize a polycrystal.

### SUMMARY OF THE INVENTION

However, in the method using a liquid encapsulating agent as disclosed by e.g. JP-A 2006-1771, H. Immenroth et.al. and M. Jurisch et.al., there are following disadvantages. For example, in the case of using B₂O₃ as a liquid encapsulating agent to prevent the sublimation and volatilization of As when synthesizing a GaAs polycrystal, a large amount of As will be absorbed into B₂O₃ that has been once used for the synthesis. In addition, since B₂O₃ has good wettability with a crucible made of PBN (Pyrolytic boron nitride), B₂O₃ may cause the peeling off of an inner wall of the crucible of PBN in a large amount due to volume shrinkage, when B₂O₃ is solidified. In the case that the crucible is once cooled down to a room temperature after synthesis of the GaAs polycrystal and the crucible that has been taken out from a synthesis furnace is transferred without any process to a reactor, if B₂O₃ and GaAs polycrystal are heated and re-melt, B₂O₃ will become cloudy to be opaque and a large amount of flakes of the crucible will be floating therein. As a result, a desired state for single crystal growth cannot be achieved. Therefore, B₂O₃ that has been once used should be removed completely, and the new B₂O₃ should be recharged before the single crystal growth. However, it is difficult to completely remove the B₂O₃ that has been once solidified. The mechanical removal of the B₂O₃ adhered to the GaAs polycrystal will increase the risk of cracking the synthesized polycrystal. Therefore, it has been generally used the technique of treating B₂O₃ with a mixture of hot water and alcohol to convert B₂O₃ into metaborate and removing the metaborate. However, this technique is very time-consuming. Further, since it is necessary to perform the wet treatment on the polycrystal as a raw material and drying the polycrystal again, the risk of contamination of the GaAs polycrystal during this process will be increased.

On the other hand, as to the technique of the synthesis reaction in a quartz ampoule as described by JP-A 5-97594**,** JP-A 6-239699**,** and JP-A 11-268904**,** there are disadvantages in that the encapsulating and opening of the quartz ampoule are required for each time, that the increase in size of the synthetic crystal is difficult due to the constraints resulting from the strength of the quartz ampoule, and that the risk of rupture of the ampoule always rises. In addition, there is another disadvantage in that inevitable contamination of Si from the quartz ampoule to the compound polycrystal makes difficult to achieve a high purity compound polycrystal.

Therefore, it is an object of the present invention to provide an equipment and a method for producing a compound polycrystal as well as a method for growing a single crystal, by which a high purity compound polycrystal can be synthesized without using any quartz ampoule and liquid encapsulating agent.

According to a feature of the invention, a method for producing a compound polycrystal that are synthesized from two or more source materials including a high vapor pressure source material having a vapor pressure higher than an atmospheric pressure at a synthesis reaction starting temperature comprises:
accommodating a starting material comprising the source materials including the high vapor pressure source material for the compound polycrystal in a reactor connected to outside through a pore;
placing the reactor accommodating the starting material in a pressure vessel and enclosing the pressure vessel;
substituting an atmosphere in the pressure vessel with an inert gas; and
constantly pressurizing an inside of the pressure vessel with a pressure not lower than a highest vapor pressure of the source material in the starting material by controlling a pressure of the inert gas while heating the reactor, to react the starting material, thereby synthesizing the compound polycrystal.

The reactor may comprise a crucible for accommodating the starting material, and a lid for covering an opening of the crucible, and wherein the lid comprises the pore.

The reactor may further comprise a connecting container to be connected to the crucible via the lid,
wherein the connecting container comprises an other pore and a region in the connecting container functions as a buffer tank of the inert gas to be flown into the crucible, and
wherein an inside of the crucible is coupled to an outside of the reactor through the pore of the lid, the region in the connecting container, and the other pore of the connecting container.

The reactor may comprise a crucible for accommodating the starting material, a lid for covering an opening of the crucible, and an outer shell container for covering the crucible and the lid,
wherein the lid comprises the pore,
wherein the outer shell container comprises an other pore and a region outside the crucible in the outer shell container functions as a buffer tank of the inert gas to be flown into the crucible, and
wherein an inside of the crucible is coupled to an outside of the reactor through the pore of the lid, the region in the outer shell container, and the other pore of the outer shell container.

The reactor may comprise a crucible for accommodating the starting material, and a lid for covering an opening and an outer side surface of the crucible,
wherein the reactor is held by a susceptor comprising the pore and being in close contact with an outer side surface of the lid,
wherein an inside of the crucible is coupled to an outside of the reactor through a gap between the outer side surface of the crucible and an inner side surface of the lid and the pore of the susceptor.

The method may further comprise:
melting the compound polycrystal after obtaining the compound polycrystal, to form a melt; and
solidifying the melt.

The melt may be solidified by unidirectional solidification by placing the melt in a region with a temperature gradient.

A volume of the crucible may be smaller than a volume of the connecting container.

A volume of the crucible may be smaller than half of a volume of the outer shell container.

During a period from starting of heating the reactor through inception of sublimation of the high vapor pressure source material until completion of reaction of the starting material, an inner wall temperature of the crucible may be constantly kept higher than a sublimation temperature of the high vapor pressure source material.

During a period from starting of heating the reactor through inception of sublimation of the high vapor pressure source material until completion of reaction of the starting material, an inner wall temperature of the crucible and the connecting container may be constantly kept higher than a solidification temperature of the high vapor pressure source material.

During a period from starting of heating the reactor through inception of sublimation of the high vapor pressure source material until completion of reaction of the starting material, an inner wall temperature of the outer shell container may be constantly kept higher than a solidification temperature of the high vapor pressure source material.

The melt may be solidified under a reduced pressure after forming the melt, by reducing a pressure in the pressure vessel to the extent that the melt does not dissociate.

According to another feature of the invention, an equipment for producing a compound polycrystal comprises:
a pressure vessel comprising a pressure control function;
a reactor installed in the pressure vessel and connected to outside through a pore, for synthesizing the compound polycrystal; and
a heater placed in the pressure vessel for heating the reactor.

The reactor may comprise a crucible for accommodating a starting material for the compound polycrystal, and a lid for the crucible, and wherein the lid comprises the pore.

The reactor may further comprise a connecting container connected to the crucible via the lid,
wherein the connecting container comprises an other pore and a region in the connecting container functions as a buffer tank of the inert gas to be flown into the crucible, and
wherein an inside of the crucible is coupled to an outside of the reactor through the pore of the lid, the region in the connecting container, and the other pore of the connecting container.

The reactor may comprise a crucible for accommodating a starting material for the compound polycrystal, a lid for the crucible, and an outer shell container for covering the crucible and the lid,
wherein the lid comprises the pore,
wherein the outer shell container comprises an other pore and a region outside the crucible in the outer shell container functions as a buffer tank of the inert gas to be flown into the crucible, and
wherein an inside of the crucible is coupled to an outside of the reactor through the pore of the lid, the region in the outer shell container, and the other pore of the outer shell container.

The reactor may comprise a crucible for accommodating a starting material for the compound polycrystal, and a lid for covering an outer side surface of the crucible,
wherein the reactor is held by a susceptor comprising the pore and being in close contact with an outer side surface of the lid,
wherein an inside of the crucible is coupled to an outside of the reactor through a gap between the outer side surface of the crucible and an inner side surface of the lid and the pore of the susceptor.

A volume of the crucible may be smaller than a volume of the connecting container.

A volume of the crucible may be smaller than half of a volume of the outer shell container.

The reactor may comprise a labyrinth structure.

According to a still another feature of the invention, a method for growing a compound single crystal comprises:
melting the compound polycrystal obtained by the above method for producing a compound polycrystal; and
contacting a seed crystal to the melt, thereby growing the compound single crystal. (Effects of the invention)

According to one embodiment of the invention, it is possible to provide an equipment and a method for producing a compound polycrystal as well as a method for growing a single crystal, by which a high purity compound polycrystal can be synthesized without using any quartz ampoule and liquid encapsulating agent.

### BRIEF DESCRIPTION OF THE DRAWINGS

Next, the present invention will be explained in more detail in conjunction with appended drawings, wherein:
**FIG.1** is a vertical cross-sectional view showing an equipment for producing a compound polycrystal in the first embodiment according to the present invention;
**FIGS.2A** to **2C** are vertical cross-sectional views schematically showing a process for synthesizing GaAs polycrystal;
**FIG.3** is a vertical cross-sectional view showing a reactor and its peripheral structure of an equipment for producing a compound polycrystal in the second embodiment according to the invention;
**FIG.4** is a vertical cross-sectional view showing a reactor and its peripheral structure of an equipment for producing a compound polycrystal in the third embodiment according to the invention;
**FIG.5** is a vertical cross-sectional view showing a reactor and its peripheral structure of an equipment for producing a compound polycrystal in the fourth embodiment according to the invention;
**FIG.6** is a vertical cross-sectional view showing a reactor and its peripheral structure of an equipment for producing a compound polycrystal in the fifth embodiment according to the invention;
**FIG.7** is a vertical cross-sectional view showing an LEC (Liquid Encapsulated Czochralski) furnace in Example **4;** and
**FIG.8** is a vertical cross-sectional view showing a raw material storage and its peripheral structure of a VGF (Vertical Gradient Freezing) furnace in Example **5.**

### DETAILED DESCRIPTION OF THE PREFERRED EMBODIMENTS

### (Summary of embodiments)

One embodiment of the present invention provides a method for producing a compound polycrystal containing one or more source materials with high vapor pressure, comprising accommodating starting material for the compound polycrystal including the source material with high vapor pressure in a reactor connected to outside through one or more pores, placing the reactor accommodating the starting material in a pressure vessel and enclosing the pressure vessel, substituting an atmosphere in the pressure vessel with an inert gas, and constantly pressurizing an inside of the pressure vessel with a pressure not lower than the highest vapor pressure of the source material in the starting material by controlling a pressure of the inert gas while heating the reactor to react the starting material, thereby synthesizing the compound polycrystal.

The "source material with a high vapor pressure" means a source material which will lose a significant amount thereof unless a means for suppressing the evaporation or sublimation is provided when the source material is heated to the synthesis reaction starting temperature of the compound polycrystal to be synthesized. The present invention is particularly effective for the synthesis with using the source material having the vapor pressure higher than the atmospheric pressure in the synthesis reaction starting temperature of the compound polycrystal. The compound polycrystal is e.g. GaAs polycrystal, and the source material having the high vapor pressure contained in the GaAs polycrystal is As.

The Inventors have obtained following findings. When the reactor for synthesizing the compound polycrystal is provided with pore(s) and placed in the gas under a pressure not lower than the vapor pressure of the source material, the inside of the reactor is filled with vapor of the source material having the high vapor pressure, and the vapor leaking from the reactor to the outside is suppressed to a very small amount only due to the diffusion through the pore(s). The present invention has been conceived based on the aforementioned findings, and the object of the invention is to synthesize the high purity compound polycrystal conveniently, by heating the reactor provided with pore(s) under the pressure not lower than the vapor pressure of the source material having a high vapor pressure, without using any liquid encapsulating agent and quartz ampoule enclosing.

### (Fist embodiment)

In the present embodiment, as an example of a method for producing a compound polycrystal according to the present invention, a method for synthesizing GaAs polycrystal from Ga and As as source materials (starting materials) will be explained below. The source material having a high vapor pressure in GaAs polycrystal is As.

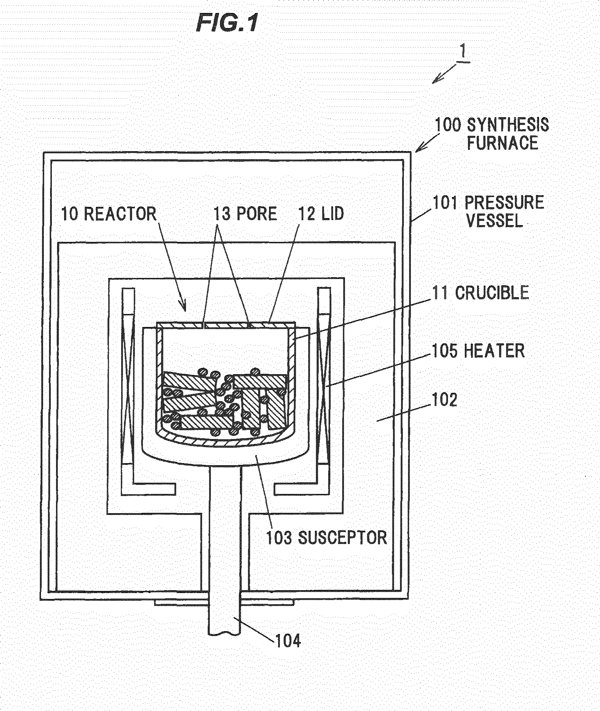

**FIG.1** is a vertical cross-sectional view showing an equipment for producing a compound polycrystal in the first embodiment. A crystal growth equipment **1** includes a synthesis furnace **100,** and a reactor **10** installed in the synthesis furnace **100.**

The reactor **10** has a crucible **11,** and a lid **12** for covering an opening of the crucible **11.** The lid **12** has pore(s) **13.** The synthesis furnace **100** includes a pressure vessel **101** having a pressure control function, a heat insulator **102** provided along an inner wall of the pressure vessel **101,** a susceptor **103** for holding the reactor **10,** a support shaft **104** for supporting the susceptor **103,** and a heater **105** for heating the reactor **10.**

The crucible **11** and the lid **12** are made of e.g. PBN (Pyrolytic Boron Nitride). PBN is preferable as the material for the crucible **11** and the lid **12,** since PBN has highly purity, low reactivity with the other material, high temperature resistance, and excellent workability for processing the pore(s).

In the present embodiment, the compound polycrystal can be synthesized without using the liquid encapsulating agent such as B₂O₃. Therefore, it is possible to place the obtained compound polycrystal without being further processed into the crystal growing furnace of VGF method or LEC method. Therefore, it is preferable to use a crucible **11** which is the same as a crucible used in the single crystal growth. For example, when using the obtained compound polycrystal as a raw material for growing a single crystal by LEC method, it is preferable to use the crucible **11** which is the same as the crucible used in LEC method. For this case, it is also possible to transfer the obtained compound polycrystal together with the crucible **11** to the crystal growth furnace of LEC method.

The inside of the crucible **11** is enclosed by the lid **12** but the gas can traverse inside and outside of the crucible **11** through the pore **13** that is provided through the lid **12.** It would be sufficient if the lid **12** covers the crucible **11** to the extent that no gap is provided between the crucible **11** and the lid **12** during the whole process of the synthesis reaction, and the lid **12** is not required to be firmly fixed by screws or the like. The shape and the number of pore(s) **13** to be provided through the lid **12** are matters of design choice that can be appropriately determined depending on e.g. the accommodated amount of the starting material, or the inner volume of the crucible **11.** In general, it would be sufficient if the lid **12** is drilled a few pores having a diameter of several millimeters.

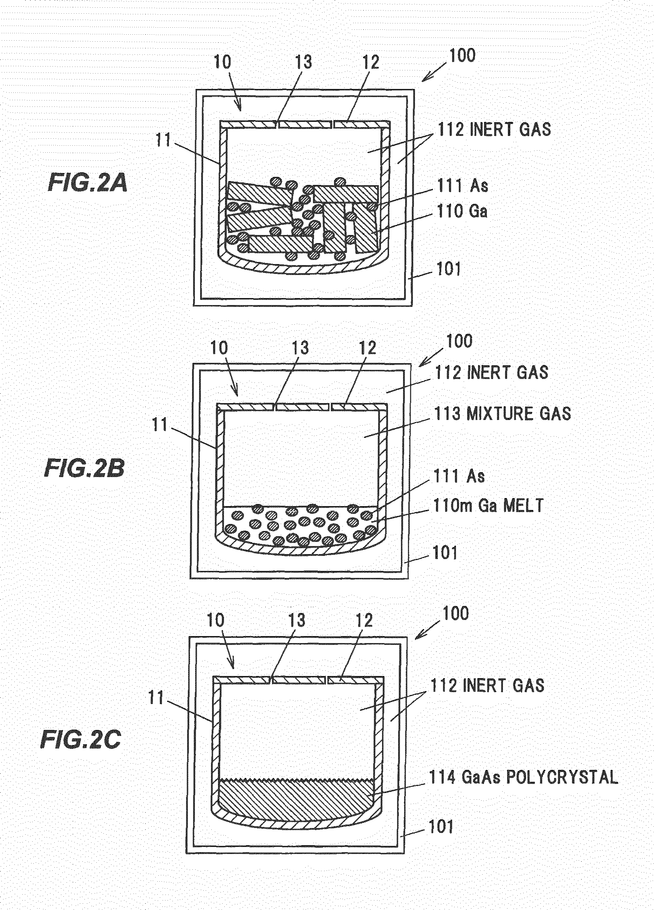

**FIGS.2**A to **2**C are vertical cross-sectional views schematically showing a process for synthesizing GaAs polycrystal. In **FIGS.2**A to **2**C, the illustration of the members other than the reactor 10 in the synthesis furnace **100** is omitted.

Firstly, as shown in **FIG.2**A, Ga **110** and As **111** are accommodated within the crucible **11** of the reactor **10,** and installed in the synthesis furnace **100.** At this time, no liquid encapsulating agent is used.

The pressure vessel **101** is tightly enclosed, and the atmosphere therein is substituted with inert gas **112** such as Ar. When the gas in the pressure vessel **101** is substituted, the inert gas **112** in the pressure vessel **101** flows into or flows out from the crucible **11** through the pore(s) **13.** Therefore, the atmosphere in the crucible **11** is the same as the inert gas **112** in the pressure vessel **101.**

As the inert gas **112,** N₂ gas or Ar gas is preferable, since the high purity gas thereof is readily available and relatively inexpensive. However, in the case that the compound to be synthesized is an oxide, the gas to be introduced into the pressure vessel **101** would not be necessarily the inert gas, and an oxygen atmosphere or an oxygen mixed atmosphere may be provided in the pressure vessel **101.**

Then, the reactor **10** is heated by the heater **105.** When the heat treatment starts, Ga **110** with a low melting point is melted first to provide Ga melt **110**m. **FIG.2**B represents the state where Ga **110** is melted.

The As **111** partially sublimes when heated, so that the inside of the crucible **11** is filled with a saturated vapor of As. However, the inside of the pressure vessel **101** is controlled to be constantly kept at pressurized with the pressure not lower than the vapor pressure of As at the temperature at that time, by controlling the pressure of the inert gas **112.** Therefore, the pressure inside the crucible **11** balances with the pressure outside the crucible **11,** so that the pressure inside the crucible **11** would not be increased to be higher than the pressure outside the crucible **11.** In other words, the inside of the crucible **11** is filled with a mixture gas **113** of the inert gas **112** and the saturated vapor of As at this temperature, the pressure inside the crucible **11** balances the pressure of the inert gas **112** which fills the outside of the pressure vessel **101.**

The mixture gas **113** inside the crucible **11** can flow out to the outside through the pore(s) **13** of the crucible **11.** However, since the pressures inside and outside the crucible **11** are equal to each other, the outflow of the mixture gas **113** is performed only by the diffusion of the gas molecules. For this reason, the amount of the As vapor flown from the crucible **11** is significantly small. In other words, further sublimation of As can be suppressed by filing the inside of the crucible **11** with the saturated As vapor. In addition, the amount of the As vapor flown out of the crucible **11** can be suppressed since the pressure inside the crucible **11** balances with the pressure outside the crucible **11** by virtue of the pore(s) **13.**

As described above, since the amount of the As vapor flown out of the crucible **11** during the process of the synthesis of GaAs polycrystal is significantly small, there is no need to use the liquid encapsulating agent of B₂O₃ or the like. Therefore, it is possible to avoid problems caused by the use of the liquid encapsulating agent as described above.

Further, it is also possible to attach an inlet tube to a pore provided at the crucible **11** in order to introduce the fresh inert gas into the crucible **11,** when the pressure inside the crucible **11** is reduced by the synthesis reaction. For this case, even if impurities such as sulfur (S), silicon (Si) volatilized from the furnace components such as the heat insulator **102,** or graphite (of the susceptor **103** and the like) are contained in the inert gas **112** in the pressure vessel **101,** the inert gas containing no impurity can be introduced into the crucible **11** through the inlet tube, so that it is possible to suppress the contamination of GaAs polycrystal to be synthesized by the impurities.

Preferably, during a period from the starting of heating the reactor **10** through the inception of sublimation of As until the completion of the synthesis reaction, the inner wall temperature of the lid **12** and crucible **11** would be constantly kept higher than the sublimation temperature of the As. This is to suppress the fall of the reaction efficiency with Ga **110,** by preventing the sublimated As vapor from being re-solidified at a low temperature portion.

Further, it is also possible to control the composition of the GaAs polycrystal to be As-rich composition according to the accommodated amount of As **111,** by accommodating As **111** excessively in the crucible **11** in advance, in order to compensate for the loss of As to be flown by the diffusion out from the crucible 11. The vapor pressure of As is about **3.7** MPa at the triple point (the temperature where solid phase, liquid phase, and vapor phase coexists, i.e. **822**°C), and the reaction with Ga **110** also occurs around this temperature, so that it is preferable to keep the pressure in the pressure vessel **101** to be **3.7** MPa or more.

When the temperature of As **111** and Ga **110** rises up to about **800**°C, As **111** reacts with Ga **110,** so that GaAs polycrystal **114** is synthesized. **FIG.2**C represents the state where the synthesis reaction is completed and GaAs polycrystal **114** is produced in the crucible **11.**

The reaction between Ga and As is an exothermic reaction, in which the temperature rises rapidly when the reaction begins and the overall reaction is completed in a short time. Most of the As vapor in the crucible **11** is lost due to chemical combination with Ga in the synthesis reaction, so that the atmosphere in the crucible **11** after completion of the synthesis reaction includes the inert gas **112** and a slight amount of the As vapor.

According to the method for producing a compound polycrystal in the present embodiment, it is preferable to carry out a step of forming a melt of synthesized GaAs polycrystal **114** by heating the crucible **11,** and a step of solidifying the melt by lowering the heater temperature, continuously after the aforementioned process of synthesizing GaAs polycrystal **114.** It is because that GaAs polycrystal produced by melting and solidifying the GaAs polycrystal **114** is excellent as a raw material for GaAs single crystal as compared with the GaAs polycrystal **114** immediately after the synthesis reaction is completed.

The GaAs polycrystal **114** immediately after the completion of the synthesis reaction has a rugged lava-like shape and includes a large number of voids therein, and a surface thereof is not flat and smooth. For this reason, if the GaAs polycrystal **114** is charged without any treatment into the LEC furnace and heated with the liquid encapsulating agent B₂O₃, the surface of the GaAs polycrystal **114** as the raw material may be not completely covered with B₂O₃ at an intermediate stage to form the melt, and a large number of bubbles may be generated in B₂O₃. Normally, the raw material polycrystal for a semi-insulating GaAs single crystal is synthesized in the As-rich composition, so that the unreacted As may be contained in the GaAs polycrystal **114** at the state immediately after the completion of the synthesis reaction. If the GaAs polycrystal **114** containing the unreacted As is charged without any treatment into the LEC furnace, the sublimation of the unreacted As may make B₂O₃ cloudy or a large amount of the sublimated As may be precipitated at a low temperature part of the furnace, thereby increasing the cleaning works.

The melt of GaAs polycrystal **114** is preferably solidified by the unidirectional solidification by placing the melt in a region with a temperature gradient, in order to form the final solidification portion of the melt at an outer surface of the GaAs polycrystal. As described above, the raw material polycrystal for the GaAs single crystal is often produced in As-rich composition. Therefore, if the final solidified portion is formed inside of the GaAs polycrystal when solidifying the melt, the excessive As will be precipitated therein, thereby causing defects such as cavities or inclusions. These defects may make B₂O₃ cloudy or generates a large number of bubbles in B₂O₃ when forming the melt in the LEC furnace. By forming the final solidification portion of the melt at an outer surface of the GaAs polycrystal, it is possible to sublimate the excessive As or remove it, as necessity.

Further, it is also possible to solidify the melt of GaAs polycrystal **114** under the reduced pressure after forming the melt, by reducing the pressure in the pressure vessel **101** to the extent that the material does not dissociate from the melt. Since a dissociation pressure of As from the GaAs melt is about **0.1** MPa, it is possible to prevent GaAs from degradation by applying the pressure higher than the dissociation pressure to the pressure vessel **101.** In consideration of the solubility of the atmosphere gas to the melt, the atmosphere pressure when solidifying the melt is preferably lowered to substantially the same as the pressure applied to the melt during the single crystal growth. This is because, if the melt solidified under the high pressure is re-melted under a pressure lower than the pressure during the solidification, the supersaturated dissolving gas may be generated as bubbles in the melt.

The compound polycrystal to be produced in the present embodiment is not limited to the GaAs polycrystal. For example, polycrystals of group III-V compound such as InAs, GaP, or InP, polycrystals of group II-VI compound such as ZnSe, or CdTe, and the like may be grown. In particular, the present invention is effective in the case of producing an undoped GaAs polycrystal for growing a semi-insulating GaAs single crystal, for which a high purity is required.

Here, the source material with a high vapor pressure contained in GaAs polycrystal or InAs polycrystal is As. The source material having a high vapor pressure contained in GaP polycrystal or InP polycrystal is P. The source material having a high vapor pressure contained in ZnSe polycrystal is Se. Further, the source materials having a high vapor pressure contained in CdTe polycrystal are Te and Cd.

### (Second embodiment)

The second embodiment differs from the first embodiment in the configuration of the susceptor and reactor. The explanation of the points similar to those in the first embodiment such as the manufacturing process of the compound polycrystal are simplified or omitted.

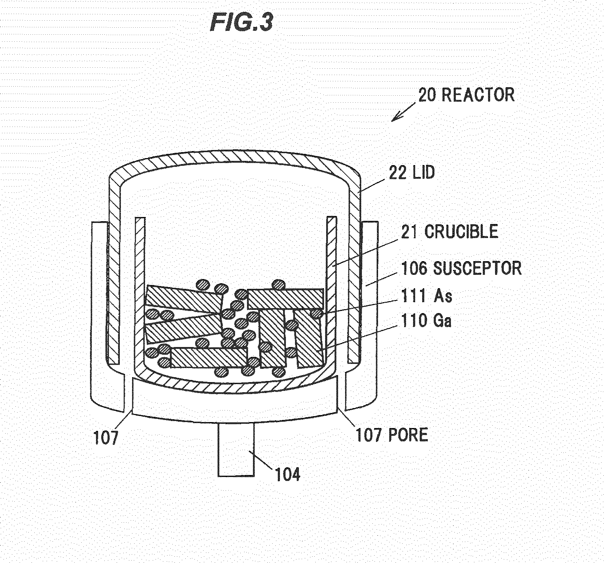

**FIG.3** is a vertical cross-sectional view showing a reactor and its peripheral structure of an equipment for producing a compound polycrystal in the second embodiment according to the invention.

A reactor **20** includes a crucible **21** for accommodating the starting material for the compound polycrystal, and a lid **22** for covering an opening and an outer side surface of the crucible **21.** The reactor **20** is held by a susceptor **106.** For example, the crucible **21** and the lid **22** are made of a material similar to the material of the crucible **11** and the lid **12** in the first embodiment.

In the same manner as the reactor **10** in the first embodiment, the reactor **20** is installed in a synthesis furnace similar to the synthesis furnace **100,** to constitute a crystal synthesis equipment. However, the susceptor **106** for the synthesis furnace in the second embodiment has pore(s) **107** unlike the susceptor **103** in the first embodiment.

A thin gap (e.g. a width of **5** mm) is provided between the outer side surface of the crucible **21** and the inner side surface of the lid **22,** and this gap constitutes the labyrinth structure of the reactor **20.** The labyrinth structure is a structure commonly known as seal structure of the gas, which is not completely enclosed and the sealing portion is provided with a narrow gap. The leakage is prevented by a large pressure loss when gas passes through the narrow gap. The labyrinth structure made by this gap is coupled to the pore(s) **107** of the susceptor **106.** Because the susceptor **106** holds the reactor **20** in close contact with the outer side surface of the lid **22,** the gas inside the reactor **20** cannot flow to the outside of the reactor **20** without passing through the pore(s) **107** of the susceptor **106.** In other words, the inside of the crucible **21** is coupled to the outside of the reactor **20** through the gap between the outer side surface of the crucible **21** and the inner side surface of the lid **22** and the pore(s) **107** of the susceptor **106.**

Therefore, the reactor **20** can suppress more effectively the flow of vapor of the starting material generated inside the reactor **20** during the process of synthesizing the compound polycrystal (e.g. As vapor generated during the process of synthesizing a GaAs polycrystal) to the outside, as compared with the reactor **10** in the first embodiment which has no labyrinth structure.

### (Third embodiment)

The third embodiment is different from the first embodiment in the configuration of the reactor. The explanation of the points similar to those in the first embodiment such as the manufacturing process of the compound polycrystal are simplified or omitted.

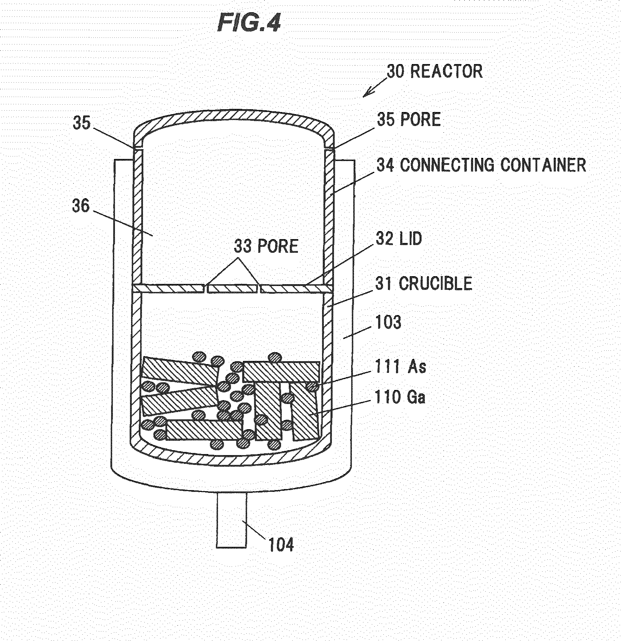

**FIG.4** is a vertical cross-sectional view showing a reactor and its peripheral structure of an equipment for producing a compound polycrystal in the third embodiment according to the invention.

A reactor **30** includes a crucible **31** for accommodating the starting material for the compound polycrystal, a lid **32** for covering an opening of the crucible **31,** and a connecting container **34** to be connected to the crucible **31** via the lid **32.** For example, the crucible **31,** the lid **32** and the connecting container **34** are made of a material similar to that of the crucible **11** and the lid **12** in the first embodiment. The lid **32** has pore(s) **33,** and the connecting container **34** has pore(s) **35.**

In the same manner as the reactor **10** in the first embodiment, the reactor **30** is installed in a synthesis furnace similar to the synthesis furnace **100,** to constitute a crystal synthesis equipment.

A region **36** inside the connecting container **34** functions as a buffer tank of an inert gas **112** flowing into the crucible **31.** As a result, the inside of the crucible **31** is coupled to the outside of the reactor **30** through the pore **33** of the lid **32,** the region **36** of the connecting container **34** and the pore **35** of the connecting container **34.**

As mentioned in the description of the first embodiment, during the process of synthesizing the GaAs polycrystal **114,** Ga **110** reacts with As **111** in the crucible **11,** so that most of As vapor filled in the crucible **11** combines with Ga **110** in a short time to form solid GaAs **114.** Therefore, the pressure inside the crucible **11** decreases rapidly, so that the inert gas **112** outside the crucible **11** is introduced into the crucible **11** through the pore **13.** At this time, if the purity of the inert gas **112** which fills the inside of the pressure vessel **101** is high enough, there will be no problem. In fact, the inert gas **112** contains a lot of impurities that are electrically active for GaAs polycrystal, so that the contamination of synthesized GaAs polycrystal occurs frequently. The impurities in the inert gas **112** are not originally contained in the inert gas **112** but posteriorly introduced, e.g., sulfur (S) or silicon (Si) that is volatilized from the furnace components such as the insulation material **102** and graphite (susceptor**103**, etc.) heated by the heater **105** in the pressure vessel **101.** If the synthesized GaAs polycrystal **114** is provided for growing an electrically conductive single crystal doped with S or Si, the problem will not be so important since the amount of impurities to be mixed is small. However, if it is desired to grow an undoped semi-insulating GaAs single crystal, there will be a problem since the semi-insulating property will be lost due to the contamination. Therefore, when synthesizing a high purity polycrystalline raw material by using an equipment configured as the crystal synthesis equipment **1** in the first and second embodiments, it is necessary to use the high purity gases and high purity source materials as a matter of course, and to use the high purity materials for the furnace components, and to pay close attention so as not to contaminate the furnace components during maintenance of the furnace.

On the other hand, according to the third embodiment, the reactor **30** includes a region **36** which functions as a buffer tank. During the rise in temperature of the pressure vessel **101,** the pressure balance between inside and outside the reactor **30** is maintained through the pore(s) **35,** the volatile impurities generated outside the reactor **30** of the pressure vessel **101** hardly enter into the region **36** as a buffer tank except the diffusion through the pore(s) **35.** For this reason, the clean inert gas **112** with less contamination by the impurity, which is introduced prior to the heating by the heater **105,** is kept in the region **36** serving as a buffer tank. Thereafter, the synthesis reaction occurs in the crucible **31,** and the pressure in the internal crucible **31** is reduced, then the clean inert gas **112** with less contamination by the impurity, which is kept in the region **36,** flows into the crucible **31** through the pore(s) **33.** At this time, the contaminated inert gas **112** outside the reactor **30** flows into the region **36** through the pore(s) **35,** but rarely flows into the crucible **31,** so that the synthetic raw material is kept with high purity. Therefore, according to the third embodiment, it is possible to synthesize a polycrystal material of high purity by using the synthesis furnace which is made of relatively inexpensive materials which can be easily maintained.

In order to maintain a clean gas in the amount greater than the inner volume of the crucible **31** in the region **36** of the connecting container **34,** thereby fully functioning the region **36** as a buffer tank, the volume of the crucible **31** is preferably smaller than the volume of the connecting container **34.**

### (Fourth embodiment)

The fourth embodiment is different from the first embodiment in the configuration of the reactor. The explanation of the points similar to those in the first embodiment such as the manufacturing process of the compound polycrystal are simplified or omitted.

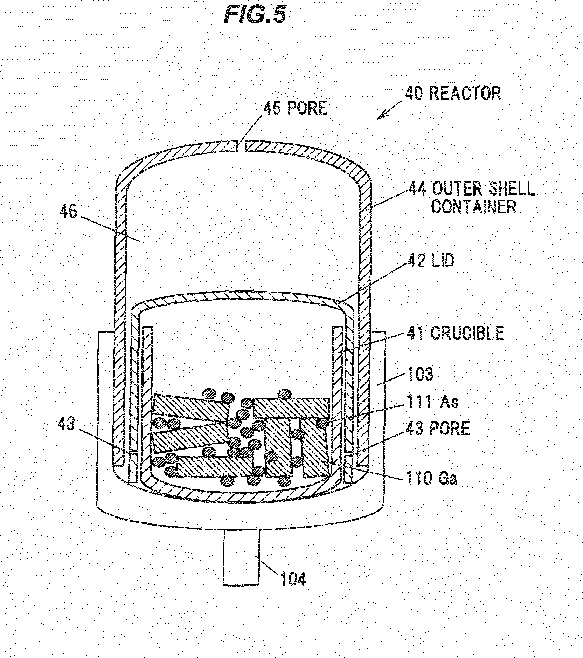

**FIG.5** is a vertical cross-sectional view showing a reactor and its peripheral structure of an equipment for producing a compound polycrystal in the fourth embodiment according to the invention.

A reactor **40** includes a crucible **41** for accommodating the starting material for the compound polycrystal, a lid **42** for covering an opening and an outer side surface of the crucible **41,** and an outer shell container **44** for covering the crucible **41** and the lid **42** downwardly. For example, the crucible **41,** the lid **42** and the outer shell container **44** are made of a material similar to that of the crucible **11** and the lid **12** in the first embodiment. The lid **42** has pore(s) **43,** and the outer shell container **44** has pore(s) **45.**

In the same manner as the reactor **10** in the first embodiment, the reactor **40** is installed in a synthesis furnace similar to the synthesis furnace **100,** to constitute a crystal synthesis equipment.

The lid **42** covers an opening and an outer side surface of the crucible **41,** and a thin gap (e.g. a width **of 5** mm) is provided between the outer side surface of the crucible **41** and the inner side surface of the lid **42.** Further, a thin gap (e.g. a width **of 5** mm) is provided between the outer side surface of the lid **42** and the inner side surface of the outer shell container **44.** Because the susceptor **103** holds the reactor **40** in close contact with the outer side surface of the outer shell container **44,** the gas inside the crucible **41** cannot flow to the outside of the reactor **40** without passing through the gap between the lid **42** and the outer shell container **44.** The gap between the crucible **41** and the lid **42** as well as the gap between the lid **42** and the outer shell container **44** constitute the labyrinth structure of the reactor **40.**

A region **46** outside the crucible **41** located inside the outer shell container **44** functions as a buffer tank of an inert gas **112** flowing into the crucible **41.** As a result, the inside of the crucible **41** is coupled to the outside of the reactor **40** through the pore(s) **43** of the lid **42,** the region **46** of the outer shell container **44** and the pore(s) **45** of the outer shell container **44.**

Since the reactor **40** has the labyrinth structure, similarly to the reactor **20** in the second embodiment, the reactor **40** can suppress more effectively the flow of vapor of the starting material generated inside the reactor **40** during the process of synthesizing the compound polycrystal (e.g. As vapor generated during the process of synthesizing a GaAs polycrystal) to the outside.

Moreover, since the reactor **40** includes the region **46** functioning as a buffer tank, similarly to the reactor **30** in the first embodiment, the reactor **40** can suppress the contamination of GaAs polycrystal **114** by the impurities generated in the pressure vessel **101.**

Further, in order to maintain a clean gas in the amount greater than the internal volume of the crucible **41** in the region **46** of the outer shell container **44,** thereby fully functioning the region **46** as a buffer tank, the volume of the crucible **41** is preferably smaller than half of the volume of the outer shell container **34.**

It should be noted that in the present embodiment the lid **12** in the first embodiment may be used instead of the lid **42** but the labyrinth structure is not configured in this case.

### (Fifth embodiment)

The fifth embodiment differs from the first embodiment in the shape of the crucible contained in the reactor. The explanation of the points similar to those in the first embodiment such as the manufacturing process of the compound polycrystal are simplified or omitted.

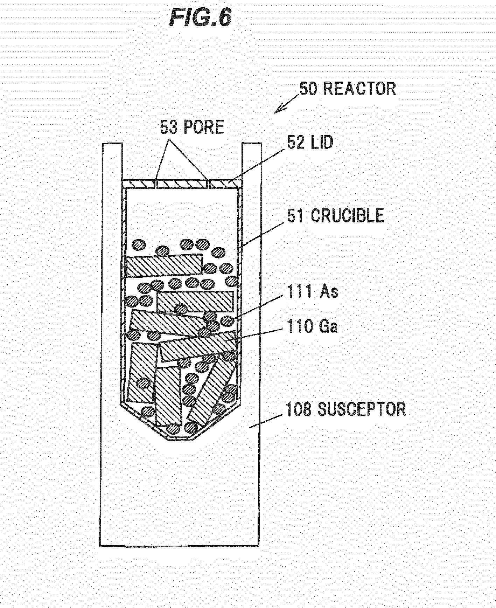

**FIG.6** is a vertical cross-sectional view showing a reactor and its peripheral structure of an equipment for producing a compound polycrystal in the fifth embodiment according to the invention.

A reactor **50** includes a crucible **51** for accommodating the starting material for the compound polycrystal, and a lid **52** for covering an opening of the crucible **51.** For example, the crucible **51** and the lid **52** are made of a material similar to that of the crucible **11** and the lid **12** in the first embodiment. The lid **52** has pore(s) **53.**

The crucible **51** has a shape suitable for the synthesis of a compound polycrystal used for growing a single crystal by VGF method. More specifically, the crucible **51** has a shape excluding a seed crystal receiving portion from the crucible used for growing a single crystal by VGF method. A straight body portion of the crucible **51** has a taper angle (e.g. **0.1**°), in which an inner diameter increases from the bottom portion toward the opening, so that the synthesized compound polycrystal can be easily pulled out.

In the present embodiment, similarly to the first embodiment, the compound polycrystal can be synthesized without using the liquid encapsulating agent such as B₂O₃, so that the untreated compound polycrystal can be placed into the crystal growth furnace of VGF method without any treatment. In the case of using VGF method, a seed crystal for growing a single crystal should be placed at the bottom of the crucible, so that the crucible **51** used for the synthesis of the compound polycrystal cannot be directly used as a crucible for growing a single crystal. On the other hand, the crucible having a shape excluding the seed crystal receiving portion from the crucible used for VGF method is preferably used as the crucible **51,** since it is possible to transfer the obtained compound single crystal without any treatment from the crucible **51** to a crucible for growing a single crystal containing a seed crystal. In this case, since the liquid encapsulating agent is not used for the synthesis of the compound polycrystal, the compound polycrystal can be pulled out from the crucible **51** very easily and simply. The same applies to the case of using the obtained compound single crystal as a raw material for single crystal growth by VB (Vertical Bridgman) method.

In the same manner as the reactor **10** in the first embodiment, the reactor **50** is installed in a synthesis furnace similar to the synthesis furnace **100,** to constitute a crystal synthesis equipment.

### (The effects of the embodiments)

According to the first to fifth embodiments, it is possible to synthesize a high purity compound polycrystal simply and conveniently, without using any quartz ampoule and liquid encapsulating agent. Further, these compound polycrystals can be synthesized using the materials and members used in the manufacturing of conventional compounds.

Further, since it is possible to eliminate the cost of liquid encapsulating agent, the economic efficiency is very good. Further, because of using no liquid encapsulating agent, the process of removing the liquid encapsulating agent from the obtained compound polycrystal becomes unnecessary. Therefore, the number of operation steps can be significantly reduced as well as the risk of contaminating the compound polycrystal can be greatly reduced. In addition, it is possible to eliminate the possibility of damaging the obtained compound polycrystal, the reactor or the like by the liquid encapsulating agent. Further, the yield of raw materials can be improved as well as the cost of auxiliary materials and consumables can be reduced.

Further, since no quartz ampoule is used in the synthesis of compound polycrystal, it is possible to eliminate the need of performing the enclosing and opening of the quartz ampoule, to obtain a large-sized compound polycrystal, and to avoid the contamination of Si from the quartz ampoule to the compound polycrystal.

### (Examples)

### (Example 1)

As Example **1,** a concrete example of the process of producing a compound polycrystal using a crystal synthesis equipment in the first embodiment will be explained below.

Firstly, Ga and As as the starting materials for GaAs polycrystal were accommodated in the reactor **10** as shown in **FIG.1****.** In the crucible **11** made of high purity PBN with a diameter of **200** mm, **5710**g of Ga **110** which is metal Ga with purity of **6**N and **6410**g of As **111** which is As with purity of **6**N were placed in the susceptor **103** made of graphite. The crucible **11** was covered with the lid **12,** which is a circular plate made of PBN and provided with six pores **13** having a diameter of **1.5** mm. The lid **12** fits into an inner wall of the susceptor **103** and is not easily displaced. The susceptor **103** accommodating the reactor **10** was installed in the heater **105** within the pressure vessel **101,** and the pressure vessel **101** was enclosed.

Next, the atmosphere in the pressure vessel **101** was substituted with argon gas as the inert gas **112,** and pressurized to **3**MPa. Then, the heating temperature was raised at a rate of about **10**°C/min to heat As **111** and Ga **110.** In accordance with the increase in temperature, the argon gas was expanded, so that the pressure in the pressure vessel **101** was raised, but it was kept in the range of **6** ± **0.1** MPa by automatic control. Since the fluctuation of the rate of temperature rise was observed around the control temperature of the heater **105** exceeding **800**°C, it was assumed that the synthesis reaction began at this point. After continuing the temperature rise of the heater **105** up to **1280**°C, the synthesized GaAs was melted and quenched by the power down of the heater **105.**

After the temperature of the pressure vessel **101** was lowered to room temperature, the pressure in the pressure vessel **101** was returned to atmospheric pressure, and the pressure vessel **101** was opened to take out the synthesized GaAs polycrystal **114.** The weight of the synthesized GaAs polycrystal **114** was **11924**g. From this, the weight of As that has been volatilized without reacting with Ga was estimated to be **196** g. As to the composition of the obtained GaAs polycrystal **114,** the molar fraction As/(Ga+As) was **0.503,** and As was excessive. As to the appearance of the obtained GaAs polycrystal **114,** the unreacted Ga was not observed, a dendritic structure was observed on the surface, and fine crystal grains were observed on the side surface. By the observation of the cross section, a region containing cavities that is deemed as final solidification structure was observed in the ingot near the inner bottom portion.

### (Example 2)

As Example **2,** a concrete example of the process of producing a compound polycrystal using a crystal synthesis equipment in the second embodiment will be explained below.

Firstly, Ga and As as the starting materials for GaAs polycrystal were accommodated in the reactor **20** as shown in **FIG.3****.** In the crucible **21** made of high purity PBN with a diameter of **190** mm and a height of **200** mm, **5700**g of Ga **110** which is metal Ga with purity of **6**N and **6300**g of As **111** which is As with purity of **6**N were placed in the susceptor **106** made of graphite. At the bottom of the susceptor **106,** a region which is not covered by the crucible **21** installed on the bottom is provided with six pores **107** having a diameter of **1.5** mm. Further, the crucible **21** was covered with the lid **22,** which is a crucible made of high purity PBN with diameter of **200** mm and a height of **240** mm, such that an opening of the lid **22** is located downwardly. The lid **22** fits into an inner wall of the susceptor **106** and is not easily displaced. According to this configuration, the inner space of the crucible **21** is coupled to the outside through the gap between the crucible **21** and the lid **22** and the pores **107** of the susceptor **106.** The width of the gap between the crucible **21** and the lid **22** is only about **5** mm, which serves as the labyrinth structure, so that the effect of suppressing the diffusion loss of the As vapor in the crucible **21.** The susceptor **106** accommodating the reactor **20** was installed in the heater **105** within the pressure vessel **101,** and the pressure vessel **101** was enclosed.

Next, the atmosphere in the pressure vessel **101** was substituted with argon gas as the inert gas **112,** and pressurized to **3**MPa. Then, the heating temperature was raised at a rate of about **10**°C/min to heat As **111** and Ga **110.** In accordance with the increase in temperature, the argon gas was expanded, so that the pressure in the pressure vessel **101** was raised, but it was kept in the range of **6 ± 0.1** MPa by automatic control. Since the fluctuation of the rate of temperature rise was observed around the control temperature of the heater **105** exceeding **850**°C, it was assumed that the synthesis reaction began at this point. After continuing the temperature rise of the heater **105** up to **1280**°C, the synthesized GaAs was melted, then the pressure of argon gas in the pressure vessel **101** was reduced to **0.2** MPa. Then, in order to solidify the GaAs melt by the unidirectional solidification from the bottom side, the susceptor **106** was lowered to a position where the bottom surface of the GaAs melt deviates from the heating region of the heater **105.** Thereafter, the temperature of the heater **105** was slowly cooled at a rate of **-10**°C/min until **800**°C, and quenched by the power down of the heater **105.** During the cooling, the pressure in the pressure vessel **101** was controlled to be constantly kept at **0.2** MPa.

After the temperature of the pressure vessel **101** was lowered to room temperature, the pressure in the pressure vessel **101** was returned to atmospheric pressure, and the pressure vessel **101** was opened to take out the synthesized GaAs polycrystal **114.** The weight of the synthesized GaAs polycrystal **114** was **11925**g. From this, the weight of As that has been volatilized without reacting with Ga was estimated to be **75** g. As to the composition of the obtained GaAs polycrystal **114,** the molar fraction As/(Ga+As) was **0.504,** and As was excessive. It is assumed that the volatilized amount of As in Example **2** was less than the volatilized amount of As in Example **1** by virtue of the effect of the labyrinth structure as described above.

As to the appearance of the obtained GaAs polycrystal **114,** the unreacted Ga was not observed, and large crystal grains were observed on the top surface and the side surface. It is assumed as the effect of reducing the pressure of the pressure vessel **101** and slowly cooling it until the solidification of the GaAs polycrystal **114.** Further, the cross section of the vertically-cut ingot was observed, and the region containing cavities or inclusions was not observed. It is assumed that the GaAs melt was solidified by the unidirectional solidification by lowering the susceptor **106** to a position where the bottom surface of the GaAs melt deviates from the heating region of the heater **105** and solidifying the GaAs melt in the region with a temperature gradient where the temperature around the bottom of the GaAs melt is low.

### (Example 3)

As Example **3,** a concrete example of the process of producing a compound polycrystal using a crystal synthesis equipment in the third embodiment will be explained below.

Firstly, Ga and As as the starting materials for GaAs polycrystal were accommodated in the reactor **30** as shown in **FIG.4****.** In the crucible **31** made of high purity PBN with a diameter of **280** mm and a height of **280** mm, **11500**g of Ga **110** which is metal Ga with purity of **6**N and **12450**g of As **111** which is As with purity of **6**N were placed in the susceptor **103** made of graphite. The crucible **31** was covered with the lid **32,** which is a circular plate made of PBN and provided with four pores **33** having a diameter of **2.0** mm. The lid **32** fits into an inner wall of the susceptor **103** and is not easily displaced. Further, the crucible **31** was covered with the connecting container **34,** which is a crucible made of high purity PBN with diameter of **280** mm and a height of **280** mm, via the lid **32,** such that an opening of the connecting container **34** is located downwardly. The connecting container **34** also fits into the inner wall of the susceptor **103** and is not easily displaced. At the side surface of the connecting container **34,** regions that are not covered by walls of the susceptor **103** are provided with four pores **35** having a diameter of **2.0** mm. The inner volume of the crucible **31** is the same as the inner volume of the connecting container **34.** However, as to the volume of an actual space in the state that Ga **110** and As **111** are accommodated, the volume of the actual inner space of the connecting container **34** is greater by the volume of Ga **110** and As **111** than the volume of the actual inner space of the crucible **31.** This inner space of the crucible **31** functions as a buffer tank as described above. The susceptor **103** accommodating the reactor **30** was installed in the heater **105** within the pressure vessel **101,** and the pressure vessel **101** was enclosed.

Next, the atmosphere in the pressure vessel **101** was substituted with argon gas as the inert gas **112,** and pressurized to **2**MPa. Then, the heating temperature was raised at a rate of about **15**°C/min to heat As **111** and Ga **110.** In accordance with the increase in temperature, the argon gas was expanded, so that the pressure in the pressure vessel **101** was raised, but it was kept in the range of **5 ± 0.1** MPa by automatic control. Since the fluctuation of the rate of temperature rise was observed around the control temperature of the heater **105** exceeding **800**°C, it was assumed that the synthesis reaction began at this point. After continuing the temperature rise of the heater **105** up to **1310**°C, the synthesized GaAs was melted, then the pressure of argon gas in the pressure vessel **101** was reduced to **0.3** MPa. Then, in order to solidify the GaAs melt by the unidirectional solidification from the bottom side, the susceptor **103** was lowered to a position where the bottom surface of the GaAs melt deviates from the heating region of the heater **105.** Thereafter, the temperature of the heater **105** was slowly cooled at a rate of -**10**°C/min until **800**°C, and quenched by the power down of the heater **105.** During the cooling, the pressure in the pressure vessel **101** was controlled to be constantly kept at **0.3** MPa.

After the temperature of the pressure vessel **101** was lowered to room temperature, the pressure in the pressure vessel **101** was returned to atmospheric pressure, and the pressure vessel **101** was opened to take out the synthesized GaAs polycrystal **114** together with the crucible **31.** The weight of the crucible **31** containing the polycrystal 114 was reduced by **18.0** g after the synthesis process as compared with the weight of the crucible **31** containing raw materials before the synthesis process. Therefore, the weight of As that has been volatilized without reacting with Ga was estimated to be **18.0** g. The weight of the synthesized GaAs polycrystal **114** was calculated to be **23932** g. As to the composition of the obtained GaAs polycrystal **114** calculated from the volatilized amount of As, the molar fraction As/(Ga+As) was **0.501,** and As was excessive.

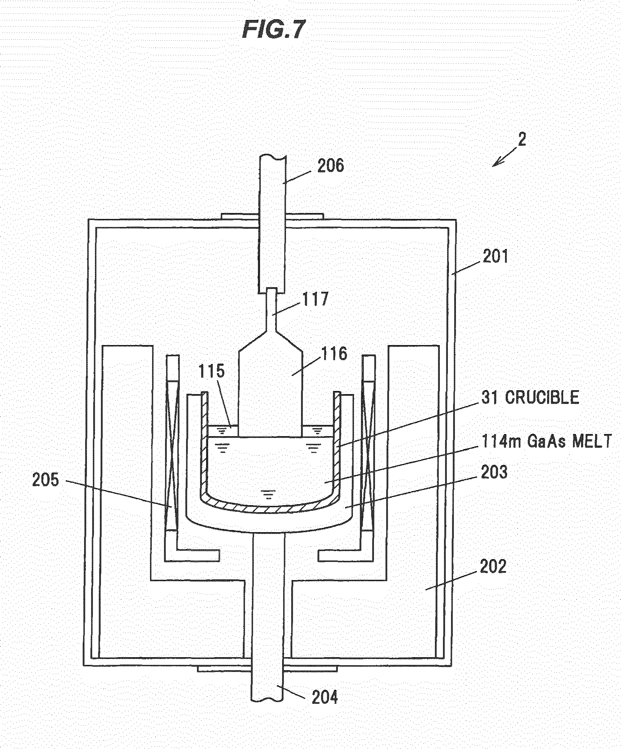

Thereafter, the synthesized GaAs polycrystal **114** was transferred to an LEC furnace **2** without removing the synthesized GaAs polycrystal **114** from the crucible **31** as shown in **FIG.7****.** The LEC furnace **2** includes a pressure vessel **201,** a heat insulator **202** provided along an inner wall of the pressure vessel **201,** a susceptor **203** for holding the crucible **31,** a support shaft **204** for supporting the susceptor **203,** and a heater **205** for heating the crucible **31.** After charging **1800**g of B₂O₃ as a liquid encapsulating agent into the crucible **31** accommodating the GaAs polycrystal **114,** the crucible **31** was heated to melt the GaAs polycrystal **114** while preventing the sublimation and volatilization of As by B₂O₃, to provide a GaAs melt **114**m.

Next, an undoped GaAs single crystal **116** with a diameter of **100** mm was grown by contacting a seed crystal **117** which is supported by a pulling shaft **206** to the melt and pulling up the seed crystal **117.** In the single crystal growth by LEC method, a GaAs single crystal **116** having a full length of **350** mm could be grown without problems such as foreign substances floating on the melt or B₂O₃. Evaluation Samples for electrical properties were prepared from a seed side (i.e. on the side of the seed crystal **117)** and a tail side of the grown GaAs single crystal **116,** and the resistivity of the samples were measured by van der Pauw method. As a result, the resistivity of the samples at the seed side and the tail side were **6.2**×**10⁷**Ω·cm and **1.6**×**10⁸**Ω·cm, respectively, and it was confirmed that the samples exhibited the semi-insulating property. Thus, it was confirmed that the GaAs polycrystal **114** has a sufficiently high purity as a raw material for semi-insulating GaAs single crystal **116.**

### (Example 4)

As Example **4,** a concrete example of the process of producing a compound polycrystal using a crystal synthesis equipment in the fourth embodiment will be explained below.

Firstly, Ga and As as the starting materials for GaAs polycrystal were accommodated in the reactor **40** as shown in **FIG.5****.** In the crucible **41** made of high purity PBN with an inner diameter of **230** mm and an outer diameter of **235** mm, **6000**g of Ga **110** which is metal Ga with purity of **6**N and **6520**g of As **111** which is As with purity of **6**N were placed in the susceptor **103** made of graphite. The crucible **41** was covered with the lid **42,** which is made of PBN and having an inner diameter of **245** mm and an outer diameter of **250** mm and provided with four pores **43** having a diameter of **2.0** mm at side surface. Further, the lid **42** is covered with the outer shell container **44** which is made of PBN and having an inner diameter of **260** mm and an outer diameter of **265** mm. The crucible **41,** the lid **42,** and the outer shell container **44** were housed concentrically inside the susceptor **103.** The outer shell container **44** fits into the inner wall of the susceptor **104** and is not easily displaced. The region **46** over the lid **42** in the outer shell container **44** functions as a buffer tank, and has a volume greater than the inner space of the crucible **41** accommodating Ga **110** and As **111.**

The gap with a width of about **5** mm between the outer side surface of the crucible **41** and the inner side surface of the lid **42** and the gap with a width of about **5** mm between the outer side surface of the lid **42** and the inner side surface of the outer shell container **44** constitute the labyrinth structure. In order to effectively suppress the diffusion of the As vapor in the crucible **41,** the pores **43** provided in the lid **42** were located at a low position in **FIG.5** such that the diffusion flow path of As is longer as possible. After the susceptor **103** which housed the reactor **40** was set in the heater **105** in the pressure vessel **101,** the pressure vessel **101** was enclosed.

Next, the atmosphere in the pressure vessel **101** was substituted with argon gas as the inert gas **112,** and pressurized to **2**MPa. Then, the heating temperature was raised at a rate of about **15**°C/min to heat As **111** and Ga **110.** In accordance with the increase in temperature, the argon gas was expanded, so that the pressure in the pressure vessel **101** was raised, but it was kept in the range of **5 ± 0.1** MPa by automatic control. Since the fluctuation of the rate of temperature rise was observed around the control temperature of the heater **105** exceeding **810**°C, it was assumed that the synthesis reaction began at this point. After continuing the temperature rise of the heater **105** up to **1300**°C, the synthesized GaAs was melted, then the pressure of argon gas in the pressure vessel **101** was reduced to **0.2** MPa. Then, in order to solidify the GaAs melt by the unidirectional solidification from the upper side, the susceptor **103** was raised to a position where the top surface of the GaAs melt deviates from the heating region of the heater **105.** Thereafter, the temperature of the heater **105** was slowly cooled at a rate of -**15**°C/min until **850**°C, and quenched by the power down of the heater **105.**
During the cooling, the pressure in the pressure vessel **101** was controlled to be constantly kept at **0.2** MPa.

After the temperature of the pressure vessel **101** was lowered to room temperature, the pressure in the pressure vessel **101** was returned to atmospheric pressure, and the pressure vessel **101** was opened to take out the synthesized GaAs polycrystal **114** together with the crucible **31.** The weight of the crucible **41** was reduced by **9.0** g after the synthesis process as compared with the weight of the crucible **41** before the synthesis process. Therefore, the weight of As that has been volatilized without reacting with Ga was estimated to be **9.0** g. The weight of the synthesized GaAs polycrystal **114** was calculated to be **12511** g. As to the composition of the obtained GaAs polycrystal **114** calculated from the volatilized amount of As, the molar fraction As/(Ga+As) was **0.503,** and As was excessive.

### (Example 5)

As Example **5,** a concrete example of the process of producing a compound polycrystal using a crystal synthesis equipment in the fifth embodiment will be explained below.

Firstly, Ga and As as the starting materials for GaAs polycrystal were accommodated in the reactor **50** as shown in **FIG.6****.** In the crucible **51** made of high purity PBN with a diameter of **80** mm and a height of **300** mm, **2915**g of Ga **110** which is metal Ga with purity of **6**N and **3180**g of As **111** which is As with purity of **6**N were placed in the susceptor **108** made of graphite. The crucible **51** has a taper angle of **0.1°** at the straight body portion, and the inner diameter increases from the bottom portion toward the opening of the straight body portion. Further, the crucible **51** was covered with the lid **52,** which is a circular plate made of PBN and provided with four pores **53** having a diameter of **1.5** mm. The lid **52** fits into an inner wall of the susceptor **108** and is not easily displaced. The susceptor **108** accommodating the reactor **50** was installed in the heater **105** within the pressure vessel **101,** and the pressure vessel **101** was enclosed.

Next, the atmosphere in the pressure vessel **101** was substituted with argon gas as the inert gas **112,** and pressurized to 3MPa. Then, the heating temperature was raised at a rate of about **10**°C/min to heat As **111** and Ga **110.** In accordance with the increase in temperature, the argon gas was expanded, so that the pressure in the pressure vessel **101** was raised, but it was kept in the range of **6** ± **0.1** MPa by automatic control. Since the fluctuation of the rate of temperature rise was observed around the control temperature of the heater **105** exceeding **820**°C, it was assumed that the synthesis reaction began at this point. After continuing the temperature rise of the heater **105** up to **1280**°C, the synthesized GaAs was melted and quenched by the power down of the heater **105.**

After the temperature of the pressure vessel **101** was lowered to room temperature, the pressure in the pressure vessel **101** was returned to atmospheric pressure, and the pressure vessel **101** was opened to take out the synthesized GaAs polycrystal **114.** Since the crucible **51** has a taper angle at the straight body portion, the ingot of the GaAs polycrystal **114** was easily pulled out from the crucible **51** only by inclining the crucible **51,** and no damage was found in the ingot of the GaAs polycrystal **114** and the crucible **51.** The weight of the GaAs polycrystal **114** thus pulled out was **6059**g. From this, the weight of As that has been volatilized without reacting with Ga was estimated to be **36** g. As to the composition of the obtained GaAs polycrystal **114,** the molar fraction As/(Ga+As) was **0.501.**

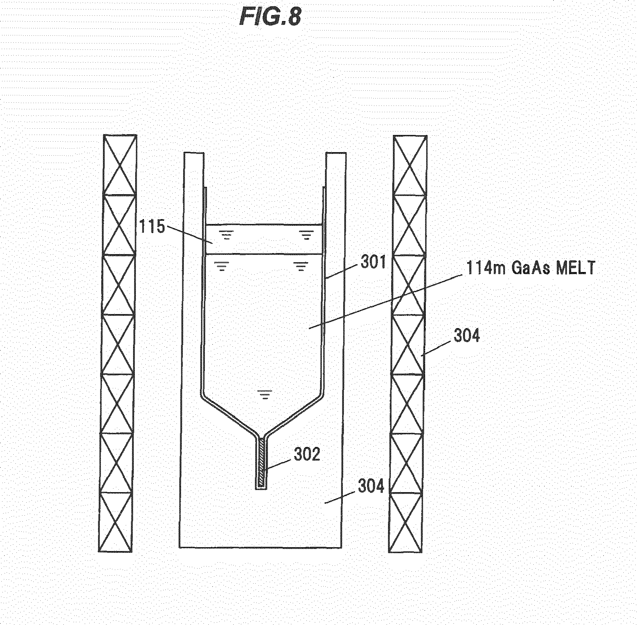

Thereafter, a growing a single crystal was carried out in a chamber-type VGF furnace by using the obtained GaAs polycrystal **114** as a raw material. **FIG.8** is a vertical cross-sectional view showing a raw material storage and its peripheral structure of a VGF furnace in Example. The untreated GaAs polycrystal **114** was filled into the crucible **301** in which the seed crystal **302** was arranged at the bottom, and **0.88**g of silicon as a dopant together with **80**g of B₂O₃ as a liquid encapsulating agent **115** were filled therein. Then, the crucible **301** was installed in the heater **304** provided in multiple stages in a chamber (not shown). After obtaining the GaAs melt **114**m by melting the GaAs polycrystal **114** by heating, a GaAs single crystal was grown from the side of the seed crystal **302.** As a result, the GaAs single crystal with a straight body portion length of about **200** mm was obtained. The carrier concentration of the wafer cut from the ingot of GaAs single crystal was measured by van der Pauw method, and an n-type conductivity of **6**×**10¹⁷**cm^{-**3**} was shown at the seed side.

Although the embodiment and Examples of the present invention have been described above, the present invention is not limited thereto and various modifications can be implemented within the scope which does not go beyond the spirit of the invention.

For example, in the aforementioned embodiments and Examples, the examples of synthesizing the compounds by placing one crucible in the pressure vessel are described. However, the present invention is not limited thereto. A plurality of crucibles may be accommodated in a large-sized pressure vessel so that a plurality of compound polycrystals can be grown simultaneously. In this case, the buffer tank of the third and fourth embodiments may be configured to be provided independently for each crucible, or alternatively, to be shared by a plurality of crucibles.

Further, in the aforementioned embodiments and Examples, the examples of synthesizing the undoped compound polycrystals are described. However, the present invention is not limited thereto. The dopant may be accommodated in the reactor in advance together with the starting material, to synthesize a compound polycrystal doped with impurities.

Still further, the present invention may be modified as follows. The inside of the container for accommodating the raw material may be provided with a raw material-receiving portion for compensation, which fills an empty space with the vapor of the raw material having a high vapor pressure, and the material having a high vapor pressure may be accommodated in the container separately from the raw material for synthesis.

In Examples **3** and **5,** the examples of transferring the synthesized compound polycrystal as it is synthesized to the single crystal growth reactor are described. However, the present invention is not limited thereto. A large-sized compound polycrystal may be synthesized and cut into small pieces to provide a raw material for growing a single crystal. In this case, since the cutting process and cleaning process are required separately, on one hand, the risk of contamination of the compound polycrystal is increased. One the other hand, if a large amount of compound polycrystal is synthesized for one time, it may lead to cost advantages.

Although the invention has been described with respect to the specific embodiments and Examples for complete and clear disclosure, the appended claims are not to be thus limited but are to be construed as embodying all modifications and alternative constructions that may occur to one skilled in the art which fairly fall within the basic teaching herein set forth. Further, it should be noted that all the combination of the features described in the embodiments and Examples is not necessarily essential for the means for solving the problem to be solved by the invention.

## Claims

1. A method for producing a compound polycrystal that are synthesized from two or more source materials including a high vapor pressure source material having a vapor pressure higher than an atmospheric pressure at a synthesis reaction starting temperature, comprising:
accommodating a starting material comprising the source materials including the high vapor pressure source material for the compound polycrystal in a reactor connected to outside through a pore;
placing the reactor accommodating the starting material in a pressure vessel and enclosing the pressure vessel;
substituting an atmosphere in the pressure vessel with an inert gas; and
constantly pressurizing an inside of the pressure vessel with a pressure not lower than a highest vapor pressure of the source materials in the starting material by controlling a pressure of the inert gas while heating the reactor, to react the starting material, thereby synthesizing the compound polycrystal.

2. The method according to claim **1,** wherein the reactor comprises a crucible for accommodating the starting material, and a lid for covering an opening of the crucible, and wherein the lid comprises the pore.

3. The method according to claim **2,** wherein the reactor further comprises a connecting container to be connected to the crucible via the lid,
wherein the connecting container comprises an other pore and a region in the connecting container functions as a buffer tank of the inert gas to be flown into the crucible, and
wherein an inside of the crucible is coupled to an outside of the reactor through the pore of the lid, the region in the connecting container, and the other pore of the connecting container.

4. The method according to any of the preceding claims, wherein the reactor comprises a crucible for accommodating the starting material, a lid for covering an opening of the crucible, and an outer shell container for covering the crucible and the lid,
wherein the lid comprises the pore,
wherein the outer shell container comprises an other pore and a region outside the crucible in the outer shell container functions as a buffer tank of the inert gas to be flown into the crucible, and
wherein an inside of the crucible is coupled to an outside of the reactor through the pore of the lid, the region in the outer shell container, and the other pore of the outer shell container.

5. The method according to any of the preceding claims, wherein the reactor comprises a crucible for accommodating the starting material, and a lid for covering an opening and an outer side surface of the crucible,
wherein the reactor is held by a susceptor comprising the pore and being in close contact with an outer side surface of the lid,
wherein an inside of the crucible is coupled to an outside of the reactor through a gap between the outer side surface of the crucible and an inner side surface of the lid and the pore of the susceptor.

6. The method according to any one of claims **1** to **5,** further comprising:
melting the compound polycrystal after obtaining the compound polycrystal, to form a melt; and
solidifying the melt.

7. The method according to claim **6,** wherein the melt is solidified by unidirectional solidification by placing the melt in a region with a temperature gradient.

8. The method according to claim **3,** wherein a volume of the crucible is smaller than a volume of the connecting container.

9. The method according to claim **4,** wherein a volume of the crucible is smaller than half of a volume of the outer shell container.

10. The method according to any one of claims **1** to **9,** wherein during a period from starting of heating the reactor through inception of sublimation of the high vapor pressure source material until completion of reaction of the starting material, an inner wall temperature of the crucible is constantly kept higher than a sublimation temperature of the high vapor pressure source material.

11. The method according to claim **3,** wherein during a period from starting of heating the reactor through inception of sublimation of the high vapor pressure source material until completion of reaction of the starting material, an inner wall temperature of the crucible and the connecting container is constantly kept higher than a solidification temperature of the high vapor pressure source material.

12. The method according to claim **4,** wherein during a period from starting of heating the reactor through inception of sublimation of the high vapor pressure source material until completion of reaction of the starting material, an inner wall temperature of the outer shell container is constantly kept higher than a solidification temperature of the high vapor pressure source material.

13. The method according to claim 6 or 7, wherein the melt is solidified under a reduced pressure after forming the melt, by reducing a pressure in the pressure vessel to the extent that the melt does not dissociate.

14. An equipment for producing a compound polycrystal, comprising:
a pressure vessel comprising a pressure control function;
a reactor installed in the pressure vessel and connected to outside through a pore, for synthesizing the compound polycrystal; and
a heater placed in the pressure vessel for heating the reactor.

15. The equipment according to claim **14,** wherein the reactor comprises a crucible for accommodating a starting material for the compound polycrystal, and a lid for the crucible, and wherein the lid comprises the pore.

16. The equipment according to claim **15,** wherein the reactor further comprises a connecting container connected to the crucible via the lid,
wherein the connecting container comprises an other pore and a region in the connecting container functions as a buffer tank of the inert gas to be flown into the crucible, and
wherein an inside of the crucible is coupled to an outside of the reactor through the pore of the lid, the region in the connecting container, and the other pore of the connecting container.

17. The equipment according to any of claims **14 to 16,** wherein the reactor comprises a crucible for accommodating a starting material for the compound polycrystal, a lid for the crucible, and an outer shell container for covering the crucible and the lid,
wherein the lid comprises the pore,
wherein the outer shell container comprises an other pore and a region outside the crucible in the outer shell container functions as a buffer tank of the inert gas to be flown into the crucible, and
wherein an inside of the crucible is coupled to an outside of the reactor through the pore of the lid, the region in the outer shell container, and the other pore of the outer shell container.

18. The equipment according to any of claims **14 to 17,** wherein the reactor comprises a crucible for accommodating a starting material for the compound polycrystal, and a lid for covering an outer side surface of the crucible,
wherein the reactor is held by a susceptor comprising the pore and being in close contact with an outer side surface of the lid,
wherein an inside of the crucible is coupled to an outside of the reactor through a gap between the outer side surface of the crucible and an inner side surface of the lid and the pore of the susceptor.

19. The equipment according to claim **16,** wherein a volume of the crucible is smaller than a volume of the connecting container.

20. The equipment according to claim **17,** wherein a volume of the crucible is smaller than half of a volume of the outer shell container.

21. The equipment according to any one of claims **14** to **20,** wherein the reactor comprises a labyrinth structure.

22. A method for growing a compound single crystal, comprising:
melting the compound polycrystal obtained by the method according to any one of claims **1** to **13,** to form a melt; and
contacting a seed crystal to the melt, thereby growing the compound single crystal.
